Europäisches Patentamt

European Patent Office

Office européen des brevets

(11) Veröffentlichungsnummer: **0 383 251**
**A2**

## (12) EUROPÄISCHE PATENTANMELDUNG

(21) Anmeldenummer: **90102767.2**

(22) Anmeldetag: **13.02.90**

(51) Int. Cl.5: **B05C 11/02, B05D 1/42**

(30) Priorität: **17.02.89 DE 3904819**

(43) Veröffentlichungstag der Anmeldung:
**22.08.90 Patentblatt 90/34**

(84) Benannte Vertragsstaaten:
**AT BE CH DE DK ES FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Hierholzer, Bernhard, Dr.**
**Dipl.-Chem.**
**Spessartstrasse 21**
**D-6000 Frankfurt/Main 60(DE)**
Erfinder: **Spiess, Wolfgang, Dr. Dipl.-Ing.**
**Rheingaustrasse 20**
**D-6110 Dieburg(DE)**
Erfinder: **Haas, Raimund, Dr. Dipl.-Ing.**
**Johannesallee 20**
**D-6230 Frankfurt/Main 80(DE)**

(54) Verfahren und Vorrichtung zum Einebnen rauher, strukturierter oder heterogener Oberflächen.

(57) Bei dem Verfahren und der Planarisiervorrichtung (1) zum Einebnen rauher, strukturierter oder heterogener Oberflächen mit einer Ausgleichsschicht (6) wird eine energiestrahldurchlässige Abdeckfolie (17) über eine Folienanpreßeinrichtung (2), die aus einem Gleitschuh und einer Vorschubeinrichtung (3) besteht, auf einen die einzuebnende Oberfläche (4) tragenden Substratträger (11) laminiert. Die Kontaktzone zwischen der Folienanpreßeinrichtung (2) und dem Substratträger (11) bildet während des Laminierens einen sich verjüngenden Laminierspalt (5), der ständig mit dem film- oder schichtbildenden organischen Beschichtungsmaterial (9) versorgt wird.

Fig. 1

EP 0 383 251 A2

# VERFAHREN UND VORRICHTUNG ZUM EINEBNEN RAUHER, STRUKTURIERTER ODER HETEROGENER OBERFLÄCHEN

Die Erfindung betrifft ein Verfahren und eine Vorrichtung zum Einebnen rauher, strukturierter oder heterogener Oberflächen von Funktionsschichten, die auf einem Substratträger aufgebracht sind, mit einem zu einer Ausgleichsschicht geformten Material.

Mehrfarbig bedruckte Farbfilterplatten mit raster- oder linienförmig aufgedruckten Farbpunkten werden geglättet, indem deren heterogene Oberflächen mit einer dünnen, einheitlichen Schicht planarisiert werden.

In der Mikroelektronikindustrie ist es häufig erwünscht, vorgefertigte Substratträger, wie Leiterplatten und Halbleiterbauelemente, mit dünnen Schichten zu belegen. Diese Schichten können vielfältige Aufgaben bei der Weiterverarbeitung und bei der Endfunktion der Bauelemente übernehmen. In strukturierter Form dienen sie beispielsweise der Stromleitung bei integrierten Schaltkreisen, sie können jedoch auch als Isolationsschichten verwendet werden. In Form von licht- bzw. strahlungsenergieempfindlichen Fotolacken dienen solche Schichten oftmals zur Strukturierung von vorsensibilisierten Substratträgern, beispielsweise von kupferkaschierten Leiterplatten, vorbehandelten Siliziumwafern oder Druckplatten.

Zur Erhöhung der lateralen Auflösung von Strukturie rungsvorgängen mit Fotoresists wird oftmals eine Planarisierungsschicht als Zwischenstufe des Herstellungsverfahrens von Elektronikbauteilen eingearbeitet, um so eine möglichst ebene Oberfläche für den aufzubringenden Fotoresist zu schaffen.

In der Patentschrift EP-B1 0 123 560 wird ein Verfahren zur Formung einer eingeebneten Schicht auf einem eine unebene Oberfläche aufweisenden, auf einem Halbleiter-Substrat geformten funktionellen Gebilde umfassend beschrieben. Das film- oder schichtbildende organische Material wird hier mittels eines geeigneten Beschichtungsverfahrens, wie des Schleuderverfahrens (Spin-Coating), auf die unebene Oberfläche aufgebracht, durch Fluidisierung mit Wärme in einem Temperprozeß geglättet und anschließend durch Strahlungsenergie ausgehärtet.

In der Zeitschrift SPIE Vol. 539, Advances in Resist Technology and Processing II (1985), S. 115 - 122 werden Modellberechnungen zur Planarisierung von strukturierten Oberflächen mit Polymerlösungen beschrieben, während in J. Electrochem. Soc.: Solid-State Science and Technology, Vol. 133, No. 1, S. 178 - 181 ein Zwei-Schicht-Planarisierungsprozeß beschrieben wird, um die Substrattopographie von Halbleiterbauelementen zu verbessern.

Auch bei der Herstellung elektro-optischer Bauteile, wie z.B. bei Flüssigkristall-Displays, spielt die Planarisierungstechnologie eine bedeutende Rolle. Ein wichtiges Bauelement eines Mehrfarben-Flüssigkristall-Displays stellt die Farbfilterplatte dar, die auf einer transparenten Platte als Substratträger, in regelmäßiger Weise angeordnet, die Grundfarben Rot, Grün und Blau in Form von Farbpunkten oder Farblinien enthält und mit der sich nach dem Prinzip der additiven Farbmischung jede Farbschattierung einschließlich Weiß und Schwarz herstellen läßt.

Die nebeneinander angeordneten Farbschichten, im folgenden als Farbpixel bezeichnet, können durch mehrere Methoden auf dem Substrat erzeugt werden. Die derzeit vorherrschende Methode besteht darin, gelatineartige Flüssigkeitsschichten aufzutragen, derart, daß die einzelnen Schichten nacheinander aufgetragen, gehärtet, mit Fotoresist strukturiert und eingefärbt werden und die jeweils auf dem Substrat verbleibenden Schichtanteile vor jedem weiteren Beschichtungsschritt mit einer geeigneten Schutzschicht versehen werden. Nach Fertigstellung des kompletten Farbmusters wird abschließend eine weitere dünne Schutzschicht aufgetragen, die eine noch vorhandene Unebenheit beseitigt und als Haftungsunterlage für nachfolgende Verfahrensschritte dient.

Eine weitere Methode zur Herstellung von Farbmustern besteht darin, die Strukturierung direkt mit pigmentiertem Resist vorzunehmen, so daß der Einfärbungsschritt entfällt.

Eine andere Methode besteht darin, die Farbschichten direkt durch konventionelle Druckverfahren, wie Offsetdruck oder Siebdruck, aufzubringen. Das Druckverfahren hat im Gegensatz zu den obengenannten Resistverfahren den erheblichen Vorteil, daß die vielfältigen Zwischenschritte, wie Resistbelichtung, Resistentwicklung, Ätzverfahren und das Aufbringen diverser Schutzschichten, entfallen und somit das Druckverfahren wesentlich billiger als ein anderes Verfahren ist. Lediglich nach Fertigstellung des gesamten Farbmusters muß eine geeignete Schutz- bzw. Planarisierungsschicht aufgebracht werden, die eine druckverfahrensbedingte Rauhigkeit der einzelnen Pixeloberflächen und gegebenenfalls einen Schichtdickenunterschied zwischen einzelnen Farbpixeln ausgleicht. Dadurch ist gewährleistet, daß die Flüssigkristallschicht, die eine Dicke von maximal 5 bis 10 Mikrometern aufweist, über die gesamte Bildschirmfläche eine möglichst konstante Dicke aufweist und Feldstärkenschwankungen sowie lokale Kurzschlüsse zwischen den auf der Ausgleichsschicht und der Gegenseite angeordneten strukturierten Elektroden vermieden werden.

Neben einer möglichst geringen Restrauhigkeit und einer großflächigen Planarität werden an solche Ausgleichsschichten oft weitere Anforderungen gestellt, wie z.B. Temperaturbeständigkeit, Lösungsmittelbeständigkeit oder genügend hohe Schichtdickenhärte.

Bei heterogenen Oberflächen, wie sie beispielsweise bei Mehrfarben-Pixeloberflächen durch die Materialzusammensetzung der einzelnen Druckfarben gegeben sind, spielt die Benetzbarkeit der Farboberflächen beim Planarisieren mit einer Ausgleichsflüssigkeit eine entscheidende Rolle. So wird es infolge der Verschiedenartigkeit einzelner Farbpigmentierungen kaum möglich sein, die Grenzflächenspannungen zwischen der flüssigen Ausgleichsschicht und den einzelnen Farben einander anzugleichen bzw. konstant einzustellen, um so einen homogenen Verlauf der Beschichtungsflüssigkeit über die gesamte heterogene Oberfläche zu gewährleisten. Der in der Patentschrift EP-B1 0 123 560 genannte Verfahrensschritt zur Fluidisierung der aufgetragenen flüssigen Ausgleichsschicht durch Wärme kann daher bei heterogenen Oberflächen zu einer unerwünschten, inhomogenen Verteilung der Flüssigkeit führen, derart, daß sich beim Fluidisieren, je nach Druckmuster der aufgebrachten Druckfarben, wellenartige oder rasterförmige Flüssigkeitsoberflächen ausbilden. Die Ursachen hierfür sind Grenzflächenphänomene infolge der angestrebten Konsistenz und Polarität des durch Strahlungsenergie härtbaren Systems.

Aufgabe der Erfindung ist es, ein Verfahren und eine Vorrichtung zu schaffen, die das Einstellen einer vorgegebenen Enddicke und ein Glätten einer Ausgleichsschicht, die eine rauhe, strukturierte oder heterogene Oberfläche eines Substratträgers einebnet, im diskontinuierlichen oder kontinuierlichen Betrieb ermöglichen.

Diese Aufgabe wird bei dem erfindungsgemäßen Verfahren durch folgende Schritte gelöst:
- Auftragen eines film- oder schichtbildenden Materials auf die einzuebnende Oberfläche,
- Laminieren des Materials zu einer Ausgleichsschicht auf der einzuebnenden Oberfläche durch eine einstellbare Anpreßkraft und eine vorgegebene Beschichtungsgeschwindigkeit,
- Einstellen der Enddicke der Ausgleichsschicht über die Anpreßkraft und die Beschichtungsgeschwindigkeit, und
- Zwangsglättung der freiliegenden Oberfläche der Ausgleichsschicht.

In Ausgestaltung des Verfahrens wird das Material der Ausgleichsschicht in einem sich verjüngenden Laminierspalt auf die zu glättende Oberfläche aufgetragen und wird die Anpreßkraft innerhalb des Laminierspalts ausgeübt. Dabei ist sichergestellt, daß der Laminierspalt kontinuierlich mit dem Material der Ausgleichsschicht versorgt wird. Während des Laminierens wird der Laminierspalt mit der Beschichtungsgeschwindigkeit entgegen der Verjüngung des Laminierspalts über die lagefeste, einzuebnende Oberfläche bewegt. In einer Variante des Verfahrens ist der Laminierspalt lagefest, und die einzuebnende Oberfläche wird mit der Beschichtungsgeschwindigkeit in Richtung des sich verjüngenden Laminierspalts bewegt.

In weiterer Ausgestaltung des Verfahrens wird die Ausgleichsschicht durch Strahlungsenergie während des Laminierens gehärtet. In allen Varianten des Verfahrens wird die freiliegende Oberfläche der Ausgleichsschicht mittels einer unter Zugspannung stehenden Abdeckfolie geglättet. Das organische Material der Ausgleichsschicht wird als Beschichtungsflüssigkeit mit einem Feststoffgehalt von 5 % bis 100 %, insbesondere von 30 % bis 70 % an energiestrahlhärtbaren Komponenten in einem Lösungsmittel auf die Oberfläche aufgetragen.

Die Vorrichtung zum Einebnen rauher, strukturierter oder heterogener Oberflächen von Funktionsschichten, die auf einem Substratträger aufgebracht sind, mit einem zu einer Ausgleichsschicht geformten Material, umfaßt eine Folienanpreßeinrichtung und eine Abrollwalze, auf der eine Abdeckfolie aufgewickelt ist, die unter der Folienanpreßeinrichtung hindurch- und an deren Unterseite entlang geführt ist, und einen Laminierspalt im Bereich der Folienanpreßeinrichtung, der sich in Abzugsrichtung der Abdeckfolie von der Abrollwalze verjüngt und mit dem film- oder schichtbildenden Material für die Ausgleichsschicht ständig gespeist wird.

In Ausgestaltung der Vorrichtung ist die Folienanpreßeinrichtung ein Gleitschuh, der über eine Druckfeder mit einer Vorschubeinrichtung verbunden ist, die den Gleitschuh mit der Beschichtungsgeschwindigkeit v horizontal über einen Ausgleichsfilm aus dem aufzulaminierenden Material auf dem lagefesten Substratträger gegen die Richtung des sich verjüngenden Laminierspalts verschiebt. Bei dieser Ausführungsform der Vorrichtung führt der Gleitschuh sowohl eine horizontale als auch eine vertikale Bewegung aus.

In einer weiteren Ausführungsform der Vorrichtung ist die Folienanpreßeinrichtung gleichfalls ein Gleitschuh, der über eine Druckfeder mit einer Haltevorrichtung verbunden ist, die eine lagefeste Haltestange und ein daran befestigtes Winkelstück umfaßt. Hier kann der Gleitschuh nur eine Vertikalbewegung ausführen, nicht jedoch eine Horizontalbewegung. Dabei wird der Gleitschuh entlang der Innenseite der senkrechten Winkelfläche des lagefesten Winkelstücks geführt, und die Druckfeder ist zwischen der Innenseite der horizontalen Winkelfläche des Winkelstücks und der Oberseite des Gleitschuhs angeordnet und preßt den Gleitschuh mit einer Anpreßkraft F gegen die auf dem Ausgleichsfilm aufliegende Abdeckfolie an, die an einer Fixierstelle auf der Oberfläche des Substratträgers befestigt ist.

In einer weiteren Abwandlung der Vorrichtung nach der Erfindung ist die Folienanpreßeinrichtung eine Folienanpreßwalze, trägt eine Beschichtungsapparatur das aufzubringende Material für den Ausgleichsfilm auf die Abdeckfolie auf und preßt die Folienanpreßwalze mit einer Anpreßkraft F die Abdeckfolie gegen den Ausgleichsfilm im Laminierspalt an.

Die Erfindung wird im folgenden anhand von schematisch dargestellten Ausführungsbeispielen erläutert. Es zeigen:

Fig. 1 eine schematische Schnittzeichnung einer ersten Ausführungsform einer diskontinuierlich arbei tenden Einebnungsvorrichtung nach der Erfindung,

Fig. 2 eine schematische Schnittzeichnung einer zweiten Ausführungsform einer kontinuierlich oder diskontinuierlich arbeitenden Einebnungsvorrichtung nach der Erfindung,

Fig. 3 eine schematische Schnittzeichnung einer dritten Ausführungsform einer kontinuierlich arbeitenden Einebnungsvorrichtung mit vordosiertem Naßfilm nach der Erfindung.

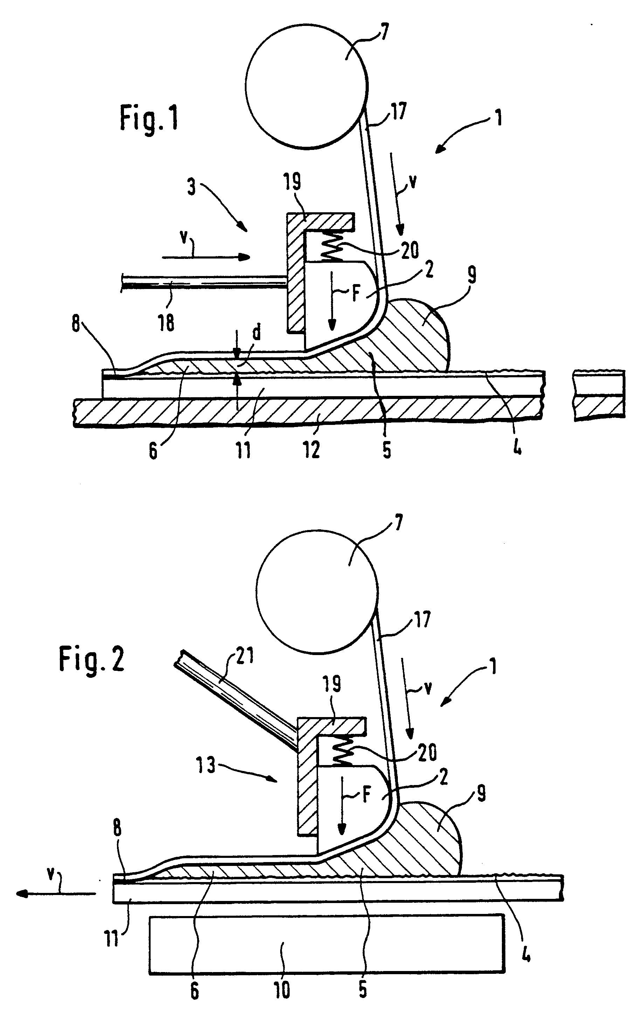

In Figur 1 ist in schematischer Schnittansicht eine erste Ausführungform einer diskontinuierlich arbeitenden Planarisierungsvorrichtung 1 nach der Erfindung dargestellt. Über einen Gleitschuh 2, der über eine Vorschubeinrichtung 18 mit der Beschichtungsgeschwindigkeit v horizontal verschiebbar ist, wird eine Abdeckfolie 17 mit konstanter vertikaler Anpreßkraft F auf einen Ausgleichsfilm 6 aus organischem Material auf der einzuebnenden strukturierten Oberfläche 4 gepreßt, die zusammen mit dem Substratträger 11 auf einer planen Unterlage 12 angeordnet ist. Durch Zugabe von Beschichtungsmaterial 9 in einen sich verjüngenden Laminierspalt 5 wird bei bewegtem Gleitschuh 2 durch Ausbildung von hydrodynamischen Kräften der Ausgleichsfilm 6 erzeugt, dessen Enddicke d über die Anpreßkraft F und die Beschichtungsgeschwindigkeit v gesteuert werden kann. Zur einwandfreien Fixierung der Abdeckfolie 17 wird diese zu Beginn der Laminierung von einer vorgespannten Abrollwalze 7 unter dem Gleitschuh hindurchgeführt und an der Fixierstelle 8 auf die Oberfläche 4 des Substratträgers 11 aufgeklebt. Die maximale Einebnungslänge ergibt sich aus der maximal möglichen Vorschublänge der Vorschubeinrichtung 3. Nach Beendigung des Einebnungsvorganges wird die Abdeckfolie 17 abgeschnitten, der beschichtete Substratträger 11 entnommen und die Ausgleichsschicht durch ein geeignetes Härtungsverfahren verfestigt.

Das Beschichtungsmaterial 9 wird zu Beginn der Beschichtung im Überschuß in den Laminierspalt 5 in Nähe des Gleitschuhes 2 gebracht, wo sich entsprechend den eingestellten Laminierbedin-. gungen selbsttätig eine bestimmte Schichtdicke d der Ausgleichsschicht 6 während des Laminierens zwischen der Oberfläche 4 und der Abdeckfolie 17 einstellt.

Die Vorschubeinrichtung 3 besteht aus einer Vorschubstange 18 und einem Winkelstück 19. Der Gleitschuh 2 liegt an der Innenseite der senkrechten Winkelfläche des Winkelstücks 19 am und wird entlang dieser Innenseite geführt. Die Druckfeder 20 befindet sich zwischen der Innenseite der horizontalen Winkelfläche des Winkelstücks 19 und der Oberseite des Gleitschuhes 2 und drückt diesen mit einer Anpreßkraft F gegen die auf dem Ausgleichsfilm 6 aufliegende Abdeckfolie 17. Die Abdeckfolie 17 wird mit einer Geschwindigkeit gleich der Beschichtungsgeschwindigkeit v durch den Gleitschuh 2 von der Abrollwalze 7 abgezogen. Die Kontaktzone zwischen dem Gleitschuh 2 und der Oberfläche 4 des Substratträgers 11 bildet während des Laminiervorgangs den sich verjüngenden Laminierspalt 5, der ständig mit dem film-oder schichtbildenden Beschichtungsmaterial 9 versorgt wird.

Figur 2 zeigt in schematischer Schnittansicht eine zweite Ausführungsform einer Planarisiervorrichtung 1 nach der Erfindung, die sowohl einen kontinuierlichen als auch diskontinuierlichen Beschichtungsbetrieb zuläßt. Der Gleitschuh 2 ist lagefest an einer Haltevorrichtung 13 angebracht. Der Substratträger 11 mit der einzuebnenden, strukturierten Oberfläche 4 wird von einer Transporteinrichtung 10 mit der Beschichtungsgeschwindigkeit v in Richtung des sich verjüngenden Laminierspaltes 5 bewegt. Die Transporteinrichtung 10 kann hierbei als endlos umlaufendes Transportband ausgeführt sein, das den Substratträger 11 über Haftungskräfte weiterbewegt. Die Transporteinrichtung 10 kann auch als ein System von Tragerollen ausgeführt sein, über welches der Substratträger 11 hinwegrollt und von dem eine oder mehrere Tragerollen angetrieben sind. Ferner kann die Transporteinrichtung 10 ein Lufttragesystem sein, so daß der bewegte Substratträger berührungslos geführt wird. In diesem Fall wird der Substratträger 11 durch eine separate Vorschubeinrichtung angetrieben, die in Figur 2 nicht gezeigt ist. Die Anpreßkraft F des Gleitschuhes 2 muß dann der Lufttragekraft das Gleichgewicht halten.

Auch bei dieser Ausführungsform ist der Gleitschuh 2 in einem Winkelstück 19 angeordnet und entlang der Innenseite der senkrechten Winkelfläche des lagefesten Winkelstückes geführt. Die Druckfeder 20 befindet sich zwischen der Innenseite der horizontalen Winkelfläche des Winkelstückes und der Oberseite des Gleitschuhes 2. Die Haltevorrichtung 13 besteht aus einer lagefesten Haltestange 21 und dem daran befestigten Winkelstück 19.

Der Gleitschuh 2 weist zwei zueinander im rechten Winkel angeordnete Flächen auf, wobei an die horizontale Oberseite des Gleitschuhs 2 eine kreisförmig gekrümmte Fläche anschließt, die über eine schräg verlaufende Planfläche mit der senkrecht verlaufenden Fläche verbunden ist. Diese schräg verlaufende Planfläche bildet die obere Begrenzungsfläche des sich verjüngenden Laminierspalts 5. Selbstverständlich kann der Gleitschuh auch einen von dem voranstehend beschriebenen Umriß abweichenden Umriß aufweisen, so kann z.B. die Verbindung zwischen den zueinander senkrecht stehenden Flächen des Gleitschuhes durch eine einzige kreis- oder ellipsenförmig gekrümmte Fläche erfolgen.

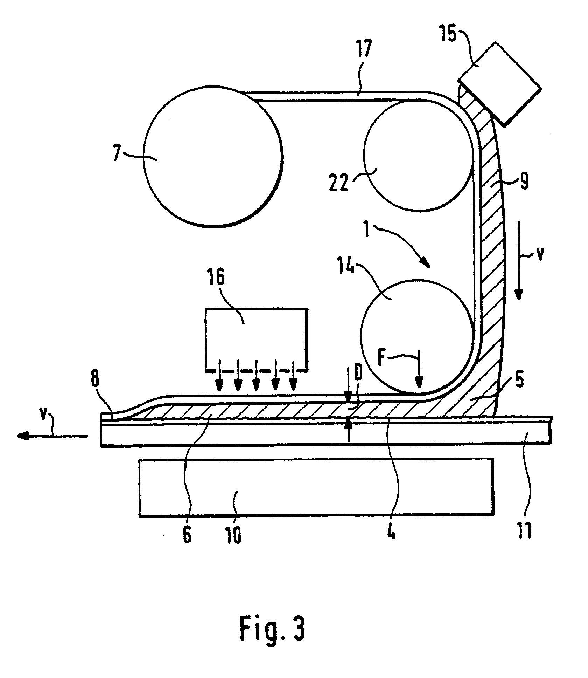

Figur 3 zeigt in schematischer Schnittansich eine dritte Ausführungsform einer Planarisiervorrichtung 1 nach der Erfindung, die anstelle des in den Figuren 1 und 2 eingesetzten Gleitschuhes 2 eine Folienanpreßwalze 14 enthält und bei der das zum Einebnen notwendige organische Material 9 in Form eines vordosierten Flüssigkeitsfilmes in den Laminierspalt 5 gebracht wird. Es wird eine Beschichtungsapparatur 15 zur Vordosierung eingesetzt, bei der es sich beispielsweise um ein Fließerantragsverfahren, Roller-Coating-Antragsverfahren, Sprühantragsverfahren oder, im Fall der diskontinuierlichen Arbeitsweise, auch um ein Siebdruckantragsverfahren handeln kann.

Zweckmäßigerweise wird die Naßfilmdicke bei vordosierter Betriebsweise auf den Sollwert der gewünschten Dicke D der Ausgleichsschicht 6 eingestellt, wobei sich im Laminierspalt 5 entsprechend den eingestellten Laminierparametern, wie Anpreßkraft F, Beschichtungsgeschwindigkeit v und Konsistenz des Beschichtungsmaterials, Dichte, Viskosität und Benetzungsfähigkeit, ein hydrodynamischer Gleichgewichtszustand erzielen läßt, der eine geschlossene Ausgleichsschicht 6 konstanter Dicke D ergibt. Ein besonderer Vorteil der dosierten Fahrweise besteht darin, daß nach dem Antrag der Ausgleichsschicht durch einen Trocknungsschritt, der vor dem Laminieren erfolgen kann, ein Teil des Lösungsmittels entfernt wird, wodurch die Konsistenz des organischen Materials den Erfordernissen angepaßt werden kann. Weiterhin entsteht durch eine sich an die Beschichtungsgeschwindigkeit v anpassende Umfangsgeschwindigkeit der Folienanpreßwalze keine Festkörperreibung, so daß hohe Anpreßkräfte F angewandt werden können.

Zweckmäßigerweise wird der zur Aushärtung der in Form eines Flüssigkeitsfilms aufgebrachten Ausgleichsschicht 6 notwendige Energiestrahler 16 direkt nach der Folienanpreßwalze 14 oberhalb des abgedeckten Substratträgers 11 angeordnet. Durch die Härtung der Ausgleichsschicht 6 mittels Energieeinstrahlung erübrigt sich bei kontinuierlicher Fahrweise die mechanische Befestigung der Folie an der Fixierstelle 8 auf dem Substratträger, da infolge des Aushärtvorganges zwischen Abdeckfolie und Ausgleichsschicht Haftungskräfte aufgebaut werden, die die Aufrechterhaltung einer kontinuierlichen Zugspannung zwischen Abrollwalze 7 und fertiglaminierter Probe sicherstellen.

Zur Initiierung, Beschleunigung und Aufrechterhaltung der über Radikale verlaufenden Energiestrahlhärtung sind die üblichen Reaktionsmittel nötig bzw. vorteilhaft. Hierbei finden, je nach System, Ketonperoxide, gegebenenfalls unter Zusatz von Metall- oder Aminbeschleunigern, Verwendung oder Fotoinitiatoren, wie die gängigen, als Sensibilisatoren verwendeten Benzoin-bzw. Acetophenonderivate.

Der Feststoffgehalt der energiestrahlhärtbaren Systeme beträgt 5 % bis 100 %, in der Regel 30 % bis 70 %, wobei unterschiedliche Lösungsmittelgemische zur Anwendung kommen und die Reaktionsmittelkonzentration zwischen 0 und 5 % variiert. Die durch das Verfahren erzielte Naßfilmdicke, welche als Folge der in der Erfindung gewählten Vorgehensweise, bis auf einen bei der Aushärtung eventuell eintretenden Schwund, der endgültigen Schichtdicke entspricht, muß größer oder gleich der maximalen Rauhtiefe der einzuebnenden Unterlage sein und liegt im Anwendungsfall von Farbfilterplatten vorteilhafterweise zwischen 1 und 5 Mikrometer.

Die speziellen Rezepturen der zur Anwendung kommenden energiestrahlhärtbaren Systeme richten sich nach den weiteren Anforderungen, wie insbesondere Temperaturbeständigkeit, Lösungsmittelbeständigkeit, Transparenz und Haftungsvermögen zu nachfolgenden Schichten. Die verwendeten Energiestrahlen reichen von IR- bis UV-Strahlung. Für die in der oben genannten Anwendung erforderlichen transparenten Ausgleichsschichten erweisen sich UV-Strahlen als besonders günstig, da im Vergleich zur ebenfalls möglichen IR-Strahlung kürzere Durchhärtzeiten erreicht werden.

Mit der Erfindung wird der Vorteil erzielt, daß eine weitgehend planare, transparente Schicht unter Berücksichtigung von Anforderungen, wie Temperaturbeständigkeit, chemische Resistenz und Haftvermögen, auf eine rauhe, strukturierte und aufgrund der Materialeigenschaften der Druckfarben unterschiedlich benetzbare Unterlage aufgebracht werden kann, wobei sehr geringe Schichtdicken im Bereich von 2 bis 6 μm realisiert werden können.

## Ansprüche

1. Verfahren zum Einebnen rauher, strukturierter oder heterogener Oberflächen von Funktionsschichten, die auf einem Substratträger aufgebracht sind, mit einem zu einer Ausgleichsschicht geformten Material, umfassend die folgenden Schritte:
- Auftragen eines film- oder schichtbildenden Materials auf die einzuebnende Oberfläche,
- Laminieren des Materials zu einer Ausgleichsschicht auf der einzuebnenden Oberfläche durch eine einstellbare Anpreßkraft und eine vorgegebene Beschichtungsgeschwindigkeit,
- Einstellen der Enddicke der Ausgleichsschicht über die Anpreßkraft und die Beschichtungsgeschwindigkeit, und
- Zwangsglättung der freiliegenden Oberfläche der Ausgleichsschicht.

2. Verfahren nach Anspruch 1, dadurch gekennzeichnet, daß das Material der Ausgleichsschicht in einem sich verjüngenden Laminierspalt auf die Oberfläche aufgetragen wird und daß die Anpreßkraft innerhalb des Laminierspalts ausgeübt wird.

3. Verfahren nach Anspruch 2, dadurch gekennzeichnet, daß der Laminierspalt kontinuierlich mit dem Material der Ausgleichsschicht versorgt wird.

4. Verfahren nach Anspruch 1, dadurch gekennzeichnet, daß der Laminierspalt mit der Beschichtungsgeschwindigkeit entgegen der Verjüngung des Laminierspaltes über die lagefeste, einzuebnende Oberfläche bewegt wird.

5. Verfahren nach Anspruch 1, dadurch gekennzeichnet, daß der Laminierspalt lagefest ist und die einzuebnende Oberfläche mit der Beschichtungsgeschwindigkeit in Richtung des sich verjüngenden Laminierspalts bewegt wird.

6. Verfahren nach Anspruch 1, dadurch gekennzeichnet, daß die Ausgleichsschicht durch Strahlungsenergie während des Laminierens gehärtet wird.

7. Verfahren nach Anspruch 1, dadurch gekennzeichnet, daß die freiliegende Oberfläche der Ausgleichsschicht mittels einer unter Zugspannung stehenden Abdeckfolie geglättet wird.

8. Verfahren nach Anspruch 1, dadurch gekennzeichnet, daß das organische Material der Ausgleichsschicht als Beschichtungsflüssigkeit mit einem Feststoffgehalt von 5 % bis 100 %, insbesondere von 30 % bis 70 % an energiestrahlhärtbaren Komponenten in einem Lösungsmittel auf die Oberfläche aufgetragen wird.

9. Vorrichtung zum Einebnen rauher, strukturierter oder heterogener Oberflächen von Funktionsschichten, die auf einem Substratträger aufgebracht sind, mit einem zu einer Ausgleichsschicht geformten Material, umfassend
- eine Folienanpreßeinrichtung (2; 14) und eine Abrollwalze (7), auf der eine Abdeckfolie (17) aufgewickelt ist, die unter der Folienanpreßeinrichtung hindurch-und an deren Unterseite entlang geführt ist,
und
- einen Laminierspalt (5) im Bereich der Folienanpreßeinrichtung (2; 14), der sich in Abzugsrichtung der Abdeckfolie von der Abrollwalze verjüngt und mit dem film- oder schichtbildenden Material (9) für die Ausgleichsschicht ständig gespeist wird.

10. Vorrichtung nach Anspruch 9, dadurch gekennzeichnet, daß die Folienanpreßeinrichtung ein Gleitschuh (2) ist, der über eine Druckfeder (20) mit einer Vorschubeinrichtung (3) verbunden ist, die den Gleitschuh (2) mit der Beschichtungsgeschwindigkeit v horizontal über einen Ausgleichsfilm (6) aus dem aufzulaminierenden Material auf dem lagefesten Substratträger (11) gegen die Richtung des sich verjüngenden Laminierspalts (5) verschiebt.

11. Vorrichtung nach Anspruch 10, dadurch gekennzeichnet, daß die Vorschubeinrichtung (3) eine Vorschubstange (18) und ein Winkelstück (19) umfaßt, daß der Gleitschuh (2) entlang der Innenseite der senkrechten Winkelfläche des Winkelstücks (19) geführt ist und daß die Druckfeder (20) zwischen der Innenseite der horizontalen Winkelfläche des Winkelstücks und der Oberseite des Gleitschuhs (2) angeordnet ist und diesen mit einer Anpreßkraft F gegen die auf dem Ausgleichsfilm (6) aufliegenden Abdeckfolie (17) anpreßt.

12. Vorrichtung nach Anspruch 9, dadurch gekennzeichnet, daß der Gleitschuh (2) die Abdeckfolie (17) mit einer Geschwindigkeit gleich der Beschichtungsgeschwindigkeit v von der Abrollwalze (7) abzieht und daß die Abdeckfolie (17) nahe dem Rand des Substratträgers (11) an einer Fixierstelle (8) auf der Oberfläche (4) des Substratträgers (11) befestigt ist.

13. Vorrichtung nach Anspruch 9, dadurch gekennzeichnet, daß die Folienanpreßeinrichtung ein Gleitschuh (2) ist, der über eine Druckfeder (20) mit einer Haltevorrichtung (13) verbunden ist, die eine lagefeste Haltestange (21) und ein daran befestigtes Winkelstück (19) umfaßt.

14. Vorrichtung nach Anspruch 13, dadurch gekennzeichnet, daß der Gleitschuh (2) entlang der Innenseite der senkrechten Winkelfläche des lagefesten Winkelstücks (19) geführt ist und daß die Druckfeder (20) zwischen der Innenseite der horizontalen Winkelfläche des Winkelstücks und der Oberseite des Gleitschuhs (2) angeordnet ist und diesen mit einer Anpreßkraft F gegen die auf dem Ausgleichsfilm (6) aufliegende Abdeckfolie (17) anpreßt, die an der Fixierstelle (8) auf der Oberfläche (4) des Substratträgers (11) befestigt ist.

15. Vorrichtung nach Anspruch 13, dadurch gekennzeichnet, daß eine Transporteinrichtung (10) den Substratträger (11) mit der Beschichtungsgeschwindigkeit v in Richtung des sich verjüngenden Laminerspalts (5) bewegt.

16. Vorrichtung nach Anspruch 9, dadurch gekennzeichnet, daß die Folienanpreßeinrichtung eine Folienanpreßwalze (14) ist, daß eine Beschichtungsapparatur (15) das aufzubringende Material (9) für den Ausgleichsfilm (6) auf die Abdeckfolie (17) aufträgt und daß die Folienanpreßwalze (14) mit einer Anpreßkraft F die Abdeckfolie (17) gegen den Ausgleichsfilm (6) im Laminierspalt (5) anpreßt.

17. Vorrichtung nach Anspruch 16, dadurch gekennzeichnet, daß eine Transporteinrichtung (10) den Substratträger (11) mit der Beschichtungsgeschwindigkeit v von dem Laminierspalt (5) weg unter einem Energiestrahler (16) hindurch bewegt, der zwischen der Folienanpreßwalze (14) und der Fixierstelle (8) auf der Oberfläche (4) des Substratträgers (11) oberhalb des abgedeckten Ausgleichsfilms (17) angeordnet ist, und daß die Strahlungsenergie den Ausgleichsfilm (6) durchhärtet.

Fig.1

Fig.2

Fig. 3